(19) Europäisches Patentamt / European Patent Office / Office européen des brevets

(11) **EP 4 704 130 A1**

(12) **EUROPEAN PATENT APPLICATION**

(43) Date of publication:
04.03.2026 Bulletin 2026/10

(21) Application number: 25196804.6

(22) Date of filing: 19.08.2025

(51) International Patent Classification (IPC):
*H01H 47/00* (2006.01)    *G01R 31/327* (2006.01)

(52) Cooperative Patent Classification (CPC):
**H01H 47/002; G01R 31/3278; H01H 47/325;**
H01H 2047/008

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: 29.08.2024 US 202418818751

(71) Applicant: Allegro MicroSystems, LLC
Manchester, NH 03103 (US)

(72) Inventors:
• **FOLETTO, Andrea**
  **13811 Andorno Micca (IT)**
• **TSHILOZ, Kavul**
  **Edinburgh, EH17 8TL (GB)**
• **TRICHY, Narasimhan**
  **Plano, 75024 (US)**

(74) Representative: **South, Nicholas Geoffrey et al**
**Venner Shipley LLP**
**200 Aldersgate**
**London EC1A 4HD (GB)**

(54) **METHOD AND SYSTEM FOR DETECTION OF RELAY CONTACTOR MOVEMENT**

(57)    A method comprising: generating, by a peak detector, a comparison signal by comparing a coil current of a relay against a dynamic threshold, the comparison signal having a first value when the coil current is above the dynamic threshold, the comparison signal having a second value when the coil current is below the dynamic threshold, wherein the peak detector is configured to: cause the dynamic threshold to track the coil current until a positive peak in the coil current is reached that has a value PP, and set the dynamic threshold to a rebound value R in response to detecting that a negative peak in the coil current is reached, the rebound value R being based on the value PP; detecting whether the relay is in a faulty state based on the comparison signal; and generating an indication of a fault when the relay is in a faulty state.

## Description

BACKGROUND

Relays are electro-mechanical devices that play a crucial role in controlling electrical circuits. They act as switches that can open or close an electrical connection when an external signal is applied. Essentially, relays serve as intermediaries between low-voltage control systems and high-voltage power circuits, ensuring the safety and efficiency of electrical operations. They are used in a wide range of applications, from industrial automation and manufacturing to telecommunications and automotive systems. Relays are especially valuable when there is a need to isolate low-voltage control circuits from high-voltage or high-current circuits to prevent damage to sensitive components or to control complex sequences of operations.

SUMMARY

According to aspects of the disclosure, a method is provided, comprising: generating, by a peak detector, a comparison signal by comparing a coil current of a relay against a dynamic threshold, the comparison signal having a first value when the coil current is above the dynamic threshold, the comparison signal having a second value when the coil current is below the dynamic threshold, wherein the peak detector is configured to: cause the dynamic threshold to track the coil current until a positive peak in the coil current is reached that has a value PP, and set the dynamic threshold to a rebound value R in response to detecting that a negative peak in the coil current is reached, the rebound value R being based on the value PP; detecting whether the relay is in a faulty state based on the comparison signal; and generating an indication of a fault when the relay is detected to be in a faulty state.

In an embodiment, the peak detector is further configured to set the dynamic threshold based on a difference between the value PP and a value M in response to detecting the positive peak.

In an embodiment, wherein the rebound value R is equal to the value PP.

In an embodiment, detecting whether the relay is in a faulty state includes identifying a count of artifacts of back electromotive force (BEMF) action in the comparison signal and determining that the relay is in a faulty state in response to the count being less than or greater than one.

In an embodiment, detecting whether the relay is in a faulty state further includes identifying a difference between the positive peak and the negative peak, and determining that the relay is in a faulty state when the difference is less than a first threshold and/or greater than the second threshold, the second threshold being greater than the first threshold.

In an embodiment, the detecting of whether the relay is in a faulty state is further performed based on a slope of a portion of a waveform of the coil current.

In an embodiment, detecting whether the relay is in a faulty state includes identifying a measure of a duration of a dip in the coil current, and determining that the relay is in a faulty state when the measure is less than a first threshold and/or greater than a second threshold, the second threshold being greater than the first threshold.

In an embodiment, the measure is identified based on the comparison signal.

In an embodiment, the detecting of whether the relay is in a faulty state is performed further based on at least one metric value that is adjusted based on temperature and/or battery voltage.

In an embodiment, the peak detector is configured to set the dynamic threshold based, at least in part, on temperature and/or battery voltage.

According to aspects of the disclosure, a system is provided, comprising: a peak detector that is configured to generate a comparison signal by comparing a coil current of a relay against a dynamic threshold, the comparison signal having a first value when the coil current is above the dynamic threshold, the comparison signal having a second value when the coil current is below the dynamic threshold, wherein generating the comparison signal includes causing the dynamic threshold to track the coil current until a positive peak in the coil current is reached that has a value PP, and setting the dynamic threshold to a rebound value R in response to detecting that a negative peak in the coil current is reached, the rebound value R being based on the value PP; and a processing circuitry that is configured to detect whether the relay is in a faulty state based on the comparison signal, and generate an indication of a fault when the relay is detected to be in a faulty state.

In an embodiment, the peak detector is further configured to set the dynamic threshold based on a difference between the value PP and a value M in response to detecting the positive peak.

In an embodiment, the rebound value R is equal to the value PP.

In an embodiment, detecting whether the relay is in a faulty state includes identifying a count of artifacts of back electromotive force (BEMF) action in the comparison signal and determining that the relay is in a faulty state in response to the count being less than or greater than one.

In an embodiment, detecting whether the relay is in a faulty state further includes identifying a difference between the positive peak and the negative peak, and determining that the relay is in a faulty state when the difference is less than a first threshold and/or greater than the second threshold, the second threshold being greater than the first threshold.

In an embodiment, the detecting of whether the relay is in a faulty state is further performed based on a slope of a portion of a waveform of the coil current.

In an embodiment, detecting whether the relay is in a faulty state includes identifying a measure of a duration of a dip in the coil current, and determining that the relay is in a faulty state when the measure is less than a first threshold and/or greater than a second threshold, the second threshold being greater than the first threshold.

In an embodiment, the measure is identified based on the comparison signal.

In an embodiment, the detecting of whether the relay is in a faulty state is performed further based on at least one metric value that is adjusted based on temperature and/or battery voltage.

In an embodiment, the peak detector is configured to set the dynamic threshold based, at least in part, on temperature and/or battery voltage.

According to aspects of the disclosure, a method is provided, comprising: generating a comparison signal $S_P$ by using a first comparator, the comparison signal $S_P$ having a first value when a coil current of a relay is above a threshold $I_P$ and a second value when the coil current is below the threshold $I_P$; generating a comparison signal $S_D$ by using a second comparator, the comparison signal $S_D$ having the first value when a coil current of a relay is above a threshold $I_D$ and the second value when the coil current is below the threshold $I_D$; detecting whether the relay is in a faulty state based on the comparison signals $S_D$ and $S_P$; and generating an indication of a fault when the relay is detected to be in a faulty state.

In an embodiment, detecting whether the relay is in a faulty state includes identifying a delay between a first type-1 edge in one of the comparison signals $S_P$ and $S_D$ and a second type-1 edge in the other one of the comparison signals $S_P$ and $S_D$, and determining that relay is in a faulty state when the delay fails to meet a delay threshold, and the second type-1 edge is a first type-1 edge in the other one of the comparison signals $S_P$ and $S_D$ that is generated after the first type-1 edge.

In an embodiment, the first type-1 edge is a rising edge and the second type-1 edge is a rising edge.

In an embodiment, the first type-1 edge is a falling edge and the second type-1 edge is a falling edge.

In an embodiment, the delay threshold is an upper bound threshold, the delay meets the upper bound threshold when the delay is less than the upper bound threshold, and the delay fails to meet the upper bound threshold when the delay is greater than the upper bound threshold.

In an embodiment, the delay threshold is a lower bound threshold, the delay meets the lower bound threshold when the delay is greater than the lower bound threshold, and the delay fails to meet the lower bound threshold when the delay is less than the lower bound threshold.

In an embodiment, the method further includes detecting a delay between a starting event and one of a positive peak and a negative peak in the coil current of the relay, wherein the detection of whether the relay is in a faulty state is further based on the delay.

According to aspects of the disclosure, a system is provided, comprising: a first comparator that is configured to generate a comparison signal $S_P$, the comparison signal $S_P$ having a first value when a coil current of a relay is above a threshold $I_P$ and a second value when the coil current is below the threshold $I_P$; a second comparator that is configured to generate a comparison signal $S_D$, the comparison signal $S_D$ having the first value when a coil current of a relay is above a threshold $I_D$ and the second value when the coil current is below the threshold $I_D$; and a processing circuitry that is configured to detect whether the relay is in a faulty state based on the comparison signals $S_D$ and $S_P$, and generate an indication of a fault when the relay is detected to be in a faulty state.

In an embodiment, detecting whether the relay is in a faulty state includes identifying a delay between a first type-1 edge in one of the comparison signals $S_P$ and $S_D$ and a second type-1 edge in the other one of the comparison signals $S_P$ and $S_D$, and determining that relay is in a faulty state when the delay fails to meet a delay threshold, and the second type-1 edge is a first type-1 edge in the other one of the comparison signals SP and SD that is generated after the first type-1 edge.

In an embodiment, the first type-1 edge is a rising edge and the second type-1 edge is a rising edge.

In an embodiment, the first type-1 edge is a falling edge and the second type-1 edge is a falling edge.

In an embodiment, the delay threshold is an upper bound threshold, the delay meets the upper bound threshold when the delay is less than the upper bound threshold, and the delay fails to meet the upper bound threshold when the delay is greater than the upper bound threshold.

In an embodiment, the delay threshold is a lower bound threshold, the delay meets the lower bound threshold when the delay is greater than the lower bound threshold, and the delay fails to meet the lower bound threshold when the delay is less than the lower bound threshold.

In an embodiment, the processing circuitry is further configured to detect a delay between a starting event and one of a positive peak and a negative peak in the coil current of the relay, and the detection of whether the relay is in a faulty state is further based on the delay.

BRIEF DESCRIPTION OF THE DRAWINGS

The foregoing features may be more fully understood from the following description of the drawings in which:

FIG. 1 is a diagram of an example of an electromagnetic relay, according to aspects of the disclosure;

FIG. 2A is a graph showing the driving voltage and coil current of the relay of FIG. 1, according to aspects of the disclosure;

FIG. 2B is a graph showing the driving voltage and coil current of the relay of FIG. 1, according to aspects of the disclosure;

FIG. 3A is a graph showing the coil current of the relay of FIG. 1, according to aspects of the disclosure;

FIG. 3B is a graph showing the coil current of the relay of FIG. 1, according to aspects of the disclosure;

FIG. 3C is a diagram of an example of a fault detector that is associated with the relay of FIG. 1, according to aspects of the disclosure;

FIG. 3D is a diagram of an example of a process that is performed by the fault detector of FIG. 3C, according to aspects of the disclosure;

FIG. 3E is a flowchart of an example of a process, according to aspects of the disclosure;

FIG. 4A is a graph illustrating aspects of the operation of the relay of FIG. 1, according to aspects of the disclosure;

FIG. 4B is a graph illustrating aspects of the operation of the relay of FIG. 1, according to aspects of the disclosure;

FIG. 4C is a graph illustrating aspects of the operation of the fault detector of FIG. 3C, according to aspects of the disclosure;

FIG. 5A is a diagram of an example of a fault detector, according to aspects of the disclosure;

FIG. 5B is a graph illustrating aspects of the operation of the fault detector of FIG. 5A, according to aspects of the disclosure;

FIG. 6A is a graph illustrating aspects of the operation of the fault detector of FIG. 5A, according to aspects of the disclosure;

FIG. 6B is a graph illustrating aspects of the operation of the fault detector of FIG. 5A, according to aspects of the disclosure; and

FIG. 7 is a flowchart of an example of a process, according to aspects of the disclosure.

DETAILED DESCRIPTION

The present disclosure provides various techniques for detecting malfunctions in a relay. The relay may be part of the battery disconnect unit (BDU) of an electric vehicle. In an electric vehicle, the BDU is a critical component that is arranged to disconnect the battery in case of failure that can lead to fire or explosion on the electric vehicle. In this regard, the techniques disclosed herein can be used to increase the fault tolerance of relays that are used in the BDUs of electric vehicles or any other safety-critical application. It will be understood that the present disclosure is not limited to any specific application of the techniques disclosed herein.

In some respects, the techniques for detecting malfunctions in a relay sense the back electromotive force (BEMF) pulse that is associated with the mechanical movement of the relay's contactor. The amplitude and length of the BEMF pulse are compared against predefined thresholds to detect anomalous movement of the relay's contactor, which might be indicative of a malfunction. For example, if the amplitude of the BEMF pulse is too short or too long, this might indicate that the relay's contactor is not moving properly, and the relay might fail completely in the future. As another example, if the BEMF pulse takes too long to develop (or if it does not develop sufficiently), this might indicate that the relay's contactor is not moving properly, and the relay might be at risk of failing. As another example, if multiple BEMFs are detected, this might indicate that the relay is experiencing a bounding condition, which signals that the relay might be on the way to failing.

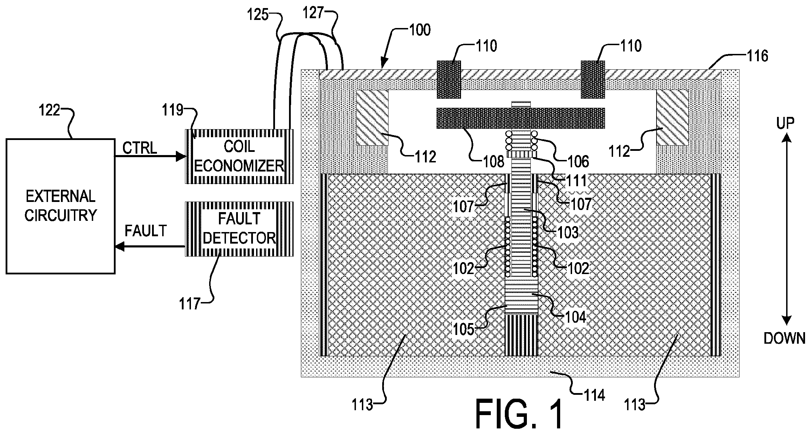

FIG. 1 is a schematic diagram of an example of an electromagnetic relay 100, according to aspects of the disclosure. As illustrated, the relay 100 may include a housing enclosure 114 arranged to contain a coil spring 102 and a moving plunger 104. The moving plunger 104 may include a portion 103 and a portion 105. Portion 105 may be arranged to engage a return spring 102 that is disposed between portion 105 and a stop 107. A moving contact 108 may be coupled to portion 103 of the plunger 104, as shown. The moving contact may be loosely coupled to portion 103 so that it can move up and down relative to portion 103. An overtravel spring 106 may be disposed between the moving contact 108 and a collar 111. Permanent magnets 112 may be disposed adjacent to the moving contact 108 and fixed contacts 110 may be disposed above the moving contact 108. An epoxy hermetic seal 116 may be arranged to partially encapsulate the fixed contact 110 to prevent moisture from entering the housing enclosure 114.

According to the present example, relay 100 is provided with a coil economizer 119 and a fault detector 117. The coil economizer 119 may include a circuit that is used to reduce the power consumption of coil 113 and improve the efficiency and longevity of the relay 100. The fault detector 117 may include circuitry configured to detect faults in the relay 100. The fault detector may be configured to generate a fault signal FAULT. When signal FAULT has a first value (*e.g.,* '0'), this may be an indication that the relay 100 is not experiencing any faults. When signal FAULT is set to a second value (*e.g.,* '1'), this may indicate that relay 100 is experiencing a faulty condition. The fault signal may be provided to external circuitry 122 that is configured to operate the relay 100.

External circuitry 122 may include a microcontroller and/or any other suitable type of circuitry. External circuitry 122 may be configured to provide coil economizer 119 with a control signal CTRL. When signal CTRL is set to a first value (*e.g.,* '1'), coil economizer 119 may toggle the relay 100 between the active and inactive states. When relay 100 is in the active state, the coil 113 is energized, which causes the plunger 104 to move up and bring moving contact 108 in electrical contact with fixed contacts 110, thus allowing electrical current to flow from one of the contacts 110 to the other. When relay 100 is in the inactive state, coil 113 may be de-energized and the return spring 102 may cause the plunger 104 to be separated from the fixed contacts 110, thus interrupting the electrical connection between fixed contacts 110.

In the example of FIG. 1, relay 100 is provided with coil economizer 119, which is electrically coupled to coil 113 via lines 125 and 127. Each of lines 125 and 127 may include a wire, a conductive trace, and/or any other suitable type of conductive member. Lines 125 and 127 may be used to energize to coil 113 and close relay 100. Although, in the present example, relay 100 is provided with a coil economizer 119, in some implementations the coil economizer 119 may be omitted. In such implementations, lines 125 and 127 may be connected directly to the external circuitry 122. FIG. 1 is provided as an example only to illustrate one of many possible architectures that can be used to implement relay 100. In this regard, it will be understood that the relay 100 is not limited to having any specific configuration.

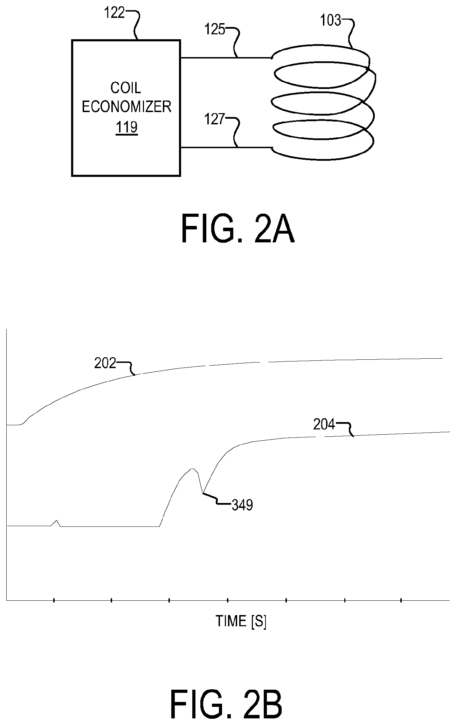

FIG. 2A shows coil 113 in further detail, according to aspects of the disclosure. In the example of FIG. 2A, coil 113 is driven by the coil economizer 119. As illustrated, the coil 113 is coupled to coil economizer 119 via conductive lines 125 and 127. One of lines 125 and 127 may be a return line and the other one of lines 125 and 127 may be a supply line for coil 113. When the relay 100 is activated, a voltage may be applied across coil 113 and electric current may begin to flow through the coil 113, which in turn may generate a magnetic field. The magnetic field may cause the plunger 104 to move up and bring the contact 108 into electrical contact with the fixed contacts 110. The electrical current through coil 113 is herein referred to as "the coil current of relay 100".

FIG. 2B is a graph illustrating aspects of the operation of coil 113. The graph includes curves 202 and 204. Curve 202 represents the voltage across the coil 113 when the coil is being activated. Curve 204 represents the coil current of relay 100 while the coil is being activated. Curve 204 includes a negative peak 349 that is caused by the back electromotive force (BEMF) which is generated in the opposite direction of the coil current when the plunger 104 starts moving.

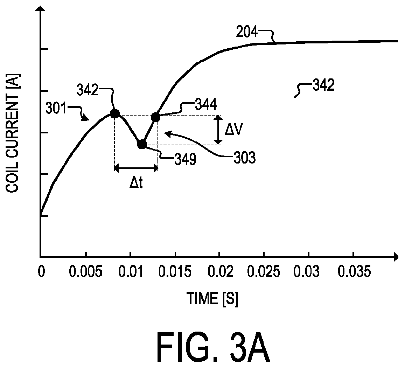

FIGS. 3A-B are plots of curve 204, which illustrate various metrics of the coil current of relay 100. Curve 204 includes an ascendant part 301 which includes a positive peak 342. The ascendant part 301 is followed by a dip 303 which includes a negative peak 349. The term "positive peak" as used throughout the disclosure refers to a local or global maximum of the waveform of the coil current of relay 100. The term "negative peak" as used throughout the disclosure refers to a local or global minimum of the waveform of the coil current of relay 100. A metric $\Delta V$ is defined as the difference between the positive peak 342 and the negative peak 349. More broadly, the value $\Delta V$ may be described as the difference between any positive peak in the waveform of the coil current of relay 100 and the first negative peak in the waveform that occurs after the positive peak.

Furthermore, according to the example of FIG. 3A, a metric $\Delta t$ is defined as the duration of the time period starting when positive peak 342 is reached by the coil current of relay 100 and ending when the coil current has reached a rebound point 344 in the waveform of the coil current of relay 100. Rebound point 344, in the present example, has the same current level as positive peak 342. In this regard, in more broad terms, the value $\Delta t$ may be described as the time it takes the coil current of relay 100 to generally rebound to the value of its most recent positive peak after it has experienced a dip.

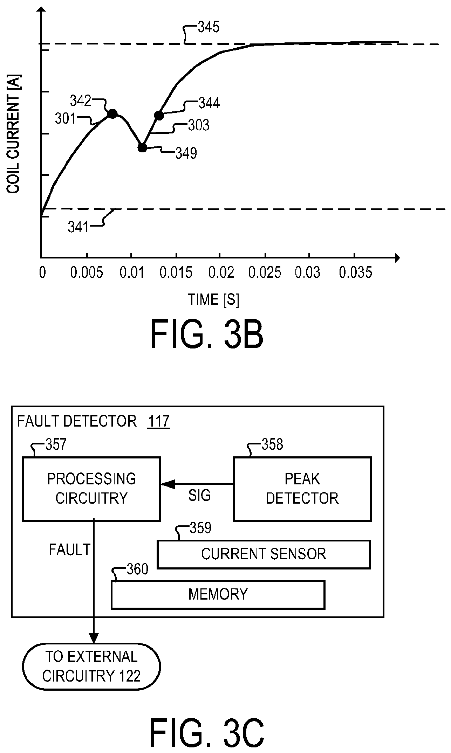

FIG. 3B shows an example of thresholds 341 and 345. Threshold 341 represents the value of the coil current that is reached immediately after the relay 100 begins to be activated. Threshold 345 represents the value of the coil current of relay 100 that is reached at the time when relay 100 has become active. The time period starting when the coil current of relay 100 crosses threshold 341 and ending when the coil current of relay 100 crosses threshold 345 is herein referred to as a "period of interest". As is discussed further below, fault detector 117 may monitor the coil current of relay 100 during the period of interest to determine when relay 100 is in a faulty state. In this regard, in some implementations, thresholds 341 and 345 are used by fault detector 117 to determine when it should start monitoring the coil current and when it should stop monitoring the coil current.

FIG. 3C is a diagram of an example of fault detector 117, according to aspects of the disclosure. As illustrated, fault detector 117 may include a processing circuitry 357, a peak detector 358, a current sensor 359, and a memory 360. Current sensor 359 may include one or more current sensors that are configured to measure the level of the coil current of relay 100 and provide the measurements to peak detector 358 and/or processing circuitry 357. Memory 360 may include any suitable type of volatile or non-volatile memory. Memory 360 may be used by processing circuitry 357 and peak detector 358 to store information that is generated or otherwise obtained by each of processing circuitry 357 and peak detector 358. Processing circuitry 357 may include any suitable type of digital or analog circuitry. By way of example, processing circuitry 357 may include digital logic, a digital controller, an application-specific circuit, a general-purpose processor, or a special-purpose processor. Peak detector 358 may include a current peak detector with hysteresis. Peak detector 358 may be configured to detect both positive and negative peaks in the coil current of relay 100. In one example, peak detector 358 may generate a signal SIG based on the coil current of relay 100 and provide the signal SIG to processing circuitry 357. Under the nomenclature of the present disclosure, the signal SIG is also referred to as a "comparison signal".

FIG. 3C is provided as an example only to show one of many possible implementations of fault detector 117 and/or edge detector 358. It will be understood that fault detector 117 and/or edge detector 358 can be implemented using any suitable type of digital and/or analog circuitry. Stated succinctly, the present disclosure is not limited to any specific implementation of fault detector 117 and/or edge detector 358.

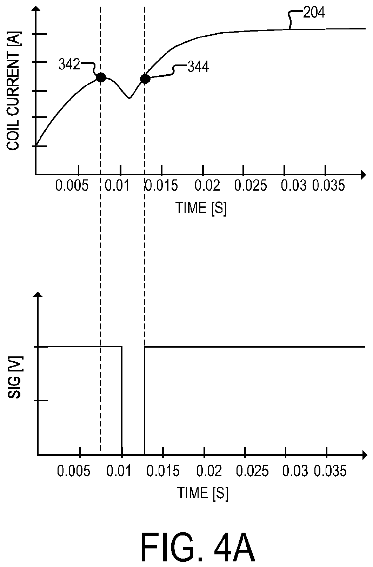

FIG. 4A shows an example of the waveform that signal SIG would have when the coil current of relay 100 has the waveform represented by curve 204. FIG. 4A shows that signal SIG is set to logic-low shortly after the coil current begins to dip (after reaching positive peak 342). FIG. 4A further shows that signal SIG remains at logic-low until the coil current of relay 100 rebounds and reaches the rebound point 344. At all other times, in the example of FIG. 4A, signal SIG is set to logic-high.

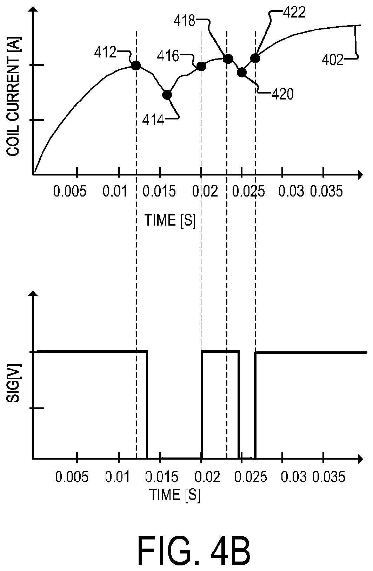

FIG. 4B shows an example of the waveform that signal SIG would have when the coil current of relay 100 has the waveform represented by a curve 402. As illustrated curve 402 has positive peaks 412 and 418 and negative peaks 414 and 420. Furthermore, curve 404 has rebound points 416 and 422, where rebound point 416 has the same current level as positive peak 412, and point 422 has the same current level as positive peak 418.

FIG. 4B shows that signal SIG is set to logic-low in the period starting shortly after the positive peak 412 and ending when rebound point 416 is reached by the coil current of relay 100. FIG. 4B further shows that signal SIG is set to logic-low in the period starting shortly after the positive peak 418 and ending when point 422 is reached by the coil current of relay 100. At all other times, signal SIG is set logic-high.

The processing circuitry 357 may process the signal SIG to determine whether the relay 100 is in a faulty state. If the relay 100 is in a faulty state, processing circuitry 357 may set the signal FAULT to a first value (e.g., logic-high). Otherwise, if the relay 100 is operating normally, processing circuitry 357 may keep the signal FAULT at a second value (e.g., logic-low).

In the example of FIGS. 4A-B, curve 204 shows the coil current of relay 100 when relay 100 is operating normally and curve 402 shows the coil current of relay 100 when relay 100 is in a faulty state. More particularly, curve 402 represents the coil current when the plunger 104 (shown in FIG. 1) is experiencing a contact bounce. A contact bounce is a condition when a relay does not close cleanly and instead makes and breaks contact, before making contact again. A contact bounce may be a sign that a relay is on the way to failing and in need of being replaced. Contact bounce is undesirable as it could lead to unintended pulses, noise, and logic errors. Contact bounce may be identified by counting the number of dips (or negative peaks) in the waveform of the coil current of relay 100.

Specifically, in the example of curve 402, the plunger 104 moves up and down and then up again, which results in there being two different dips in the curve 402. The two dips correspond to troughs in the signal SIG. Thus, in one implementation, processing circuitry 357 may count the throughs in signal SIG during a period of interest and determine that relay 100 is in a faulty state in response to detecting that the signal SIG has more than one through occurring in the period of interest.

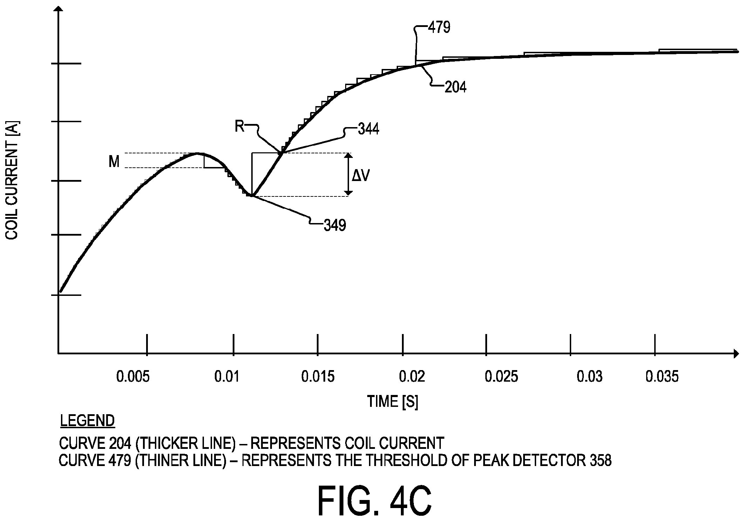

Peak detector 358 may be implemented by using any suitable type of digital or analog electronic circuitry. As noted, peak detector 358 may use a dynamic threshold value to detect positive and negative peaks in the coil current of relay 100. The value of the dynamic threshold is represented by a curve 479, which is shown in FIG. 4C together with curve 204 of the coil current of relay 100.

In some respects, FIG. 4C illustrates that before the coil current of relay 100 reaches a positive peak, while the value of the coil current is rising, the threshold may be incremented by a nominal increment Q every time the threshold is crossed. In other words, before the positive peak 342 is reached, while the value of the coil current is rising, the threshold of peak detector 358 tracks the coil current of relay 100. When a positive peak is reached, the current value of the threshold is decremented by a value M, where M is larger than the value Q. For example, M may be twice as larger, five times larger, 20 times larger, and so forth. The value M may be stored in the memory 360 (shown in FIG. 3C) and it may be part of the configuration settings of fault detector 117.

In the example, of FIG. 4C, the threshold has a value PP when the positive peak 342 is reached and the threshold is set to equal a value U, which is equal to the difference between PP and M (i.e., U= PP-M) in response to the positive peak 342 being reached. After the value U is crossed by the coil current of relay 100, and while the coil current is decreasing, the threshold is decremented by the value Q every time it is crossed. In other words, the threshold begins to track the value of the coil current after the coil current falls below the value U. As used throughout the disclosure, the phrase "tracking the value of the coil current" refers to: (i) the threshold being repeatedly updated to a value that is just slightly larger than the current coil current value while coil current is rising, and (ii) the threshold being repeatedly updated to a value that is just slightly smaller than the current coil current value while the coil current is falling. In some implementations, the value Q by which the threshold of peak detector 358 is decremented and incremented when the threshold is tracking the coil current of relay 1, may be equal to 0.1% or 0.01% of the expected dynamic range of the coil current, whereas the value M may be substantially larger (*e.g.,* 5% or 15% or the expected work).

After the negative peak 349 is reached by the coil current, the threshold is set to a rebound value R. According to the present example, the value R is equal to the value of the threshold when positive peak 342 is reached by the coil current (*i.e.,* R=PP). However, in alternative implementations the value R may be a different value, for example the value R may be set to equal a fraction of PP, such as 90% or 80% of PP. For example, the value R may be equal to the product PP and a factor n (*i.e.,* R=n*PP), wherein n is number stored in the memory 360 (shown in FIG. 3C), which is part of the configuration settings of fault detector 117.

After the value R is crossed by the coil current, and while the coil current is rising, the threshold continues to be incremented by the value Q. Although, in the present example, the threshold is incremented and decremented by the same value (*i.e.,* Q) alternative implementations are possible in which the threshold is incremented by one value and decremented by a different value.

In summary, the peak detector 358 may be configured to set the value of its dynamic threshold by executing the following process: (i) the value of the threshold tracks the value of the coil current while the coil current is rising and before the next positive peak is reached, (ii) the current value of the threshold is decremented by a value M once a positive peak is reached, (iii) after the decremented value of the threshold is crossed, the threshold tracks the value of the coil current until a negative peak is reached, (iv) after the negative peak is reached, the threshold is set to a rebound value R which is equal to or otherwise based on the value of the threshold when the most recent positive peak in the coil current was reached, and (v) the after the rebound value R is crossed by the coil current, the process returns to step (i).

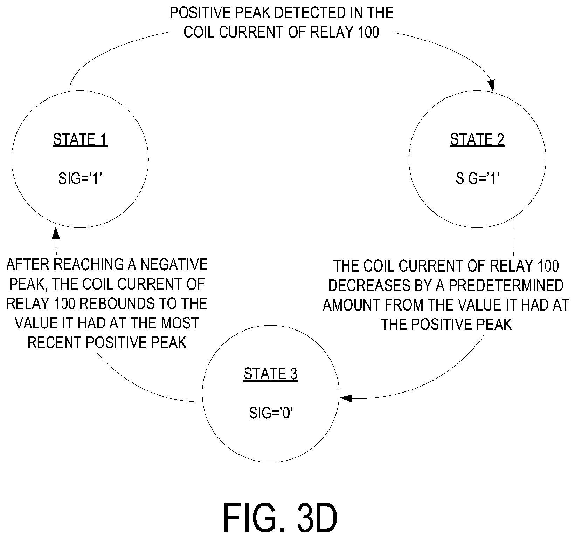

FIG. 3D is a state diagram illustrating aspects of the operation of peak detector 358. FIG. 3D illustrates that when in operation, peak detector 358 may assume one of three states, which are herein enumerated as state 1, state 2, and state 3.

State 1. Upon entering state 1, peak detector 358 sets the value of signal SIG to a first value (*e.g.,* logic-high) and starts searching for a positive peak in the coil current of relay 100. Peak detector 358 increases the value of its threshold (*e.g.,* by the value Q) if the coil current is increasing. When the coil current starts decreasing, after having increased for a while, peak detector 358 determines that a positive peak has been reached. Peak detector 358 transitions from state 1 to state 2 when it has detected the next positive peak in the coil current of relay 100. In the present example, the "next" or "most-recently detected" positive peak of the coil current has a peak value of PP. In some implementations, peak detector 358 may use the last value of its threshold before the coil current starts decreasing as the peak value PP. The peak value PP may be stored in a memory, such as the memory 360 (shown in FIG. 3C). Upon peak detector 358 exiting state 1, the coil current of relay 100 starts to decrease (relative to the peak value PP).

State 2. Upon entering state 2, peak detector 358 continues to monitor the level of the coil current of relay 100. Furthermore, upon entering state 2, peak detector 358 sets its threshold value to equal the difference between the peak value PP and a predefined minimum value M (called hysteresis). Specifically, the threshold value may be set in accordance with equation 1 below, where U is the threshold value:

$$U = PP - M \ (1)$$

In response to detecting that the coil current of relay 100 has crossed the threshold of peak detector 358 (defined by equation 1), peak detector 358 may set the signal SIG to a second value (*e.g.,* logic-low). Moreover, after the threshold U=PP-M is crossed, peak detector 358 starts to continuously decrease the value of its threshold (*e.g.,* by the value Q) while the coil current of relay 100 is decreasing. The threshold is decreased until the coil current of the relay 100 starts to rise again, at which point, the peak detector 358 determines that a negative peak in the coil current has been identified.

In the present example, the "next" or "most-recently detected" negative peak of the coil current has a peak value of NP. In some implementations, peak detector 358 may use the last value of its threshold before the coil current starts increasing as the peak value NP. The peak value NP may be stored in memory 360 (shown in FIG. 3C). Upon peak detector 358 exiting state 1, the coil current of relay 100 starts to decrease (relative to the peak value NP). After the negative peak in the coil current of relay 100 is detected, the signal SIG is maintained at the second value (*e.g.,* logic-low), the threshold of the peak detector is set to the rebound value R, and the peak detector 358 transitions from state 2 to state 3. As noted above, the value R may be equal to or otherwise based on the value PP.

According to aspects of the disclosure, the value M needs to be set to detect the minimum acceptable BEMF pulse of relay 100. In this regard, a BEMF dip that is too small would not be detected and/or identified by a matching through in signal SIG. In this regard, when the signal SIG does not contain any throughs during the predetermined period (discussed above), processing circuitry 357 may determine that the relay 100 is a faulty state in which the movement of plunger 104 is too slow indicating internal friction (*e.g.,* due to the accumulation of dirt or debris) or a problem with the coil 113. In both cases the relay 100 (and/or contact 108) will not operate properly and a failure behavior needs to be reported.

State 3. When peak detector 358 enters state 3, the coil current of relay 100 is on the rise, and the threshold of peak detector 358 is equal to the rebound value R. Peak detector 358 holds the signal SIG at the second value until the coil current of relay 100 has crossed the threshold. In response to detecting that the coil current of relay 100 has reached the rebound value R, peak detector transitions from state 3 to state 1, where signal SIG is set back to the first value.

In some implementations, the threshold (and/or the values PP and NP) may be further adjusted based on battery voltage and temperature to achieve a higher accuracy. For example, in instances in which the relay 100 is driven by a battery, and the voltage of the battery has decreased (due to the battery being depleted), the value of the threshold (and/or the value PP) may also be decreased. In some implementations, the reduction may be performed in accordance with equations 2 and 3 below:

$$T = P * T * k \quad (2)$$

$$P = \left(\frac{CV}{BV}\right) \quad (3)$$

Where T is the threshold of peak detector 358 (or any other metric that is being adjusted, such as the values PP and NP), k is a scaling factor (*e.g.,* k=1, k=0.5, k=1.5, *etc.*), CV is the instant voltage of the battery used to drive relay 100, and BV is the voltage which the battery has when it is fully charged.

Similarly, the adjustment of the threshold (and/or another metric, such as the values NP and PP) may be performed in accordance with equations 4 and 5 below:

$$T = W * T * k \quad (4)$$

$$W = \left(\frac{CT}{RT}\right) \quad (5)$$

Where T is the threshold of peak detector 358 (and/or the value of any other metric that is being adjusted, such as the values NP and/or PP), k is a scaling factor (*e.g.,* k=1, k=0.5, k=1.5, *etc.*), CT is the current temperature of the relay 100, and RT is room temperature. In some implementations, any of values NP and PP may be adjusted based on temperature and/or battery voltage before the values NP and PP are used to calculate the value $\Delta V$, which may be subsequently used to determine if the relay 100 is in a faulty state.

In some implementations, the duration of the time period $\Delta t$ (shown in FIG. 3A), which starts when the most recent positive peak is detected (in stage 1) and ends when the coil current returns to the peak value PP of the most recent positive peak (in stage 3) is an indication of the speed at which the contact 108 travels. Processing circuitry 357 may calculate the value $\Delta t$ and determine if this value is out of predetermined bounds. If the value is out of the predetermined bounds, processing circuitry 357 may determine that relay 100 is in a faulty state. In other words, the value $\Delta t$ may also be used by processing circuitry 357 to discriminate between faulty and normal behavior.

In some implementations, the amplitude $\Delta V$ (shown in FIG. 3A) of the negative peak of the coil current, which is equal to the values PP and NN, may also be used to judge the health of relay 100. Processing circuitry 357 may calculate the value $\Delta V$ and determine if this value is out of predetermined bounds. If the value is out of the predetermined bounds, processing circuitry 357 may determine that relay 100 is in a faulty state.

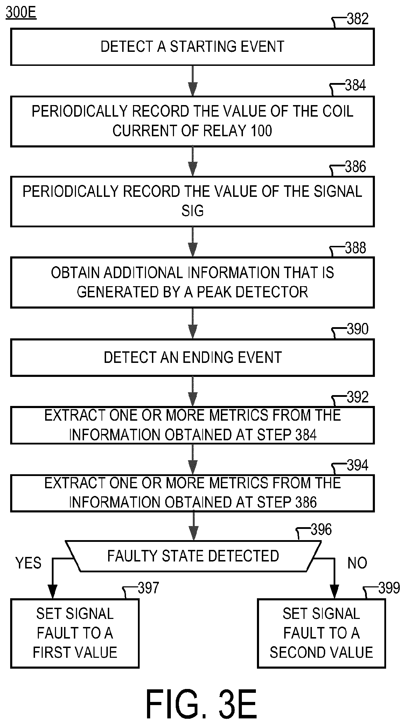

FIG. 3E is a flowchart of an example of a process 300E, according to aspects of the disclosure.

At step 382, processing circuitry 357 detects a starting event. The starting event may be any event that signals that relay 100 is beginning to transition from the inactive state to the active state - *i.e.,* any event that signals that the relay 100 is starting to close. In one example, detecting the starting event may include detecting that the coil current of relay 100 has crossed threshold 341 (shown in FIG. 3B).

At step 384, processing circuitry 357 periodically records (and/or samples) the value of the coil current of relay 100.

At step 386, processing circuitry 357 periodically records (and/or samples) the value of the signal SIG.

At step 388, processing circuitry 357 obtains any other information that is gathered by peak detector 358. The collected information may include one or more of the value PP, the value NP, the duration of the time period $\Delta t$, and/or any other information.

At step 390, processing circuitry 357 detects an ending event. The ending event may be any event that signals that relay 100 has transitioned into the active state- *i.e.,* any event that signals that the relay 100 is closed. In one example, detecting the starting event may include detecting that the coil current of relay 100 has crossed the threshold 345 (shown in FIG. 3B).

At step 392, processing circuitry 357 extracts one or more metrics based on the values of the coil current that are collected at step 384. In one example, the coil current values collected at step 384 may be sufficient in number and frequency to represent the waveform of the coil current during the period starting when the starting event is detected and ending when the ending event is detected (hereinafter "period of interest"). In this regard, any of the collected metrics may be the slope of a particular section of the waveform. The section may be a section starting when the waveform reaches a particular value (*e.g.,* when the waveform crosses threshold 341, which is shown in FIG. 3B) and ending when waveform reaches a positive peak (*e.g.,* positive peak 342, shown in FIG. 3B). In another example, the section may be a section starting at a negative peak and ending when the waveform rebounds to the value of the most recent positive peak. Additionally or alternatively, in some implementations, processing circuitry 357 may adjust one or more of the slopes based on the voltage of a battery that is used to drive the relay 100 and/or based on the temperature of relay 100.

For example, in instances in which the relay 100 is driven by a battery, and the voltage of the battery has decreased (due to the battery being depleted), any of the slope values may also be decreased. In some implementations, the reduction may be performed in accordance with equations 6 and 7 below:

$$S = P * S * k \quad (6)$$

$$P = \left(\frac{CV}{BV}\right) \quad (7)$$

Where S is a slope value, k is a scaling factor (*e.g.,* k=1, k=0.5, k=1.5, *etc.*), CV is the instant voltage of the battery used to drive relay 100, and BV is the voltage which the battery has when it is fully charged.

Similarly, the adjustment of a slope value based on temperature may be performed in accordance with equations 8 and 9 below:

$$S = W * S * k \quad (8)$$

$$W = \left(\frac{CT}{RT}\right) \quad (9)$$

Where S is the slope value, k is a scaling factor (*e.g.,* k=1, k=0.5, k=1.5, *etc.*), CT is the current temperature of the relay 100, and RT is room temperature. It will be understood that equations 1-9 are provided to illustrate one of many possible ways of adjusting a metric value based on battery voltage and/or temperature. In this regard, it will be understood that the present disclosure is not limited to any specific method for adjusting a metric value based on battery voltage or temperature.

At step 394, processing circuitry 357 extracts one or more metrics based on the values of the signal SIG that are collected at step 386. In one example, the coil current values collected at step 386 may be sufficient in number and frequency to represent the waveform of the signal SIG during the period of interest. In this regard, any of the collected metrics may be the number of throughs int the waveform of signal SIG, the delay between any two consecutive throughs in the signal SIG, and so forth. Under the nomenclature of the present disclosure, the throughs in signal SIG are referred to as "artifacts indicative of BEMF action" because they are representative of dips in the coil current of relay 100 that are caused by a BEMF kickback from the plunger 104 (shown in FIG. 1). However, in implementations in which the logic of signal SIG is inverted, such that the peaks in the signal SIG correspond to the dips in the coil current of relay 100, the peaks in signal SIG may be regarded as "artifacts indicative of BEMF action".

At step 396, processing circuitry 357 processes information obtained at steps 390, 392, and 394 to determine whether relay 100 is in a faulty state. If relay 100 is found to be in a faulty state, process 300E proceeds to step 397. Otherwise, if relay 100 is found to be operating normally (*i.e.,* not in a faulty state), process 300E proceeds to step 399.

At step 397, processing circuitry 357 sets signal FAULT to a first value (*e.g.,* '1').

At step 399, processing circuitry 357 sets signal FAULT to a second value (*e.g.,* '0').

Although in the present example, the signal FAULT is a 1-bit signal, in alternative implementations the signal FAULT may be a multi-bit signal. In such implementations, when the relay 100 is found to be in a faulty state, the value of the signal FAULT may be set to an error code that identifies the metric whose being out of bounds led processing circuitry 357 to conclude that relay 100 was in a faulty state.

In some implementations, processing circuitry 357 may determine that relay 100 is in a faulty state when any of the metrics obtained at steps 390, 392, and 394 is out of bounds. For example, when signal SIG includes only one artifact that is indicative of BEMF action, processing circuitry 357 may determine that relay 100 is operating normally. On the other hand, when signal SIG includes zero or more than one artifacts that are indicative of BEMF action, processing circuitry may determine that relay 100 in a faulty state. In another example, when any value $\Delta t$ for the coil current waveform is less than a first threshold and/or greater than a second threshold (the second threshold being greater than the first threshold), processing circuitry 357 may determine that relay 100 is in a faulty state. In yet another example, when any value $\Delta V$ for the coil current waveform is less than a first threshold and/or greater than a second threshold (the second threshold being greater than the first threshold), processing circuitry 357 may determine that relay 100 is in a faulty state. In yet another example, when the slope of a section of the coil current curve is less than a first threshold and/or greater than a second threshold (the second threshold being greater than the first threshold), processing circuitry 357 may determine that relay 100 is in a faulty state.

In some implementations, the value $\Delta t$ may be replaced with the duration of the through in the signal SIG (or the duration of any artifact of BEMF action in the signal SIG.). In other words, instead of keeping track of the temporal delay between a pair of positive and negative peaks in the coil current of relay 100, processing circuitry 357 may process signal SIG to determine the duration of the through (*i.e.,* the duration of the time period starting when signal SIG is set to logic-low and ending when signal SIG is set to logic-high), and use the determined duration to detect whether relay 100 is in a faulty state. For instance, if the duration is less than a first threshold and/or greater than a second threshold (the second threshold being greater than the first threshold), processing circuitry 357 may determine that relay 100 is in a faulty state. Otherwise, processing circuitry 357 may determine that relay 100 is operating normally. Under the nomenclature of the present disclosure, the value $\Delta t$ or the duration of a through (or another artifact of BEMF action) in the signal SIG, which corresponds to the same dip in the coil current of relay 100, are both referred as "a measure of the duration of a dip in the coil current of relay 100".

As noted above, in some implementations, the value of $\Delta V$ may be calculated by subtracting the value PP of the positive peak 342 (shown in FIG. 3) from the value NP of the negative peak 349 (shown in FIG. 3). In some implementations, before the value of $\Delta V$ is calculated and used as a basis for determining whether relay 100 is in a faulty state, the value NP and/or PP may be adjusted based on temperature and/or battery voltage. Similarly, the value $\Delta t$ and/or the slope of a particular section of the current coil curve may be adjusted based on temperature and/or battery voltage. Specifically, the value $\Delta t$ may be adjusted by virtual of adjustments for temperature and/or battery voltage that are performed on the dynamic threshold of peak detector 358 (shown in FIG. 3). As indicated by equations 1-9, adjusting any metric value based on temperature and/or battery voltage includes identifying a number of percentage points by which the temperature and/or battery voltage deviates from a baseline value (*e.g.,* such as room temperature or fully-charged voltage) and increasing or decreasing by the same number of percentage points (from its current value) the metric that is being adjusted. For example, if the temperature and/or battery voltage is above the baseline value, the metric value may also be increased; similarly, if the temperature and/or battery voltage is below the baseline value, the metric may be decreased.

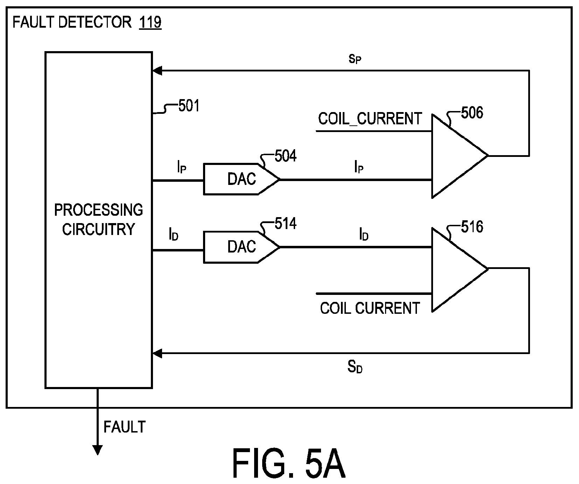

FIG. 5A is a diagram of fault detector 119 in accordance with another implementation. In the example of FIG. 5A, fault detector 117 includes a processing circuitry 501, a digital to analog converter (DAC) 504, a comparator 506, a DAC 514, and a comparator 516. Processing circuitry 501 may have the same or similar configuration as processing circuitry 357, which is discussed above with respect to FIG. 3C. In operation, processing circuitry 501 may provide to DAC 504 a signal that is indicative of the value of a threshold $I_P$. DAC 504 may convert the value of threshold $I_P$ to analog format and provide the converted threshold $I_P$ to comparator 506. Comparator 506 may compare the value of threshold $I_P$ to the value of the coil current of relay 100 and output a signal $S_P$ based on the outcome of the comparison. Processing circuitry 501 may provide to DAC 514 a signal that is indicative of the value of a threshold $I_D$. DAC 514 may convert the threshold $I_D$ to analog format and provide the converted threshold to comparator 506. Comparator 516 may compare the value of threshold $I_D$ to the value of the coil current of relay 100 and output a signal $S_D$ based on the outcome of the comparison. Under the nomenclature of the present disclosure, signals $S_D$ and $S_P$ are also referred to as "comparison signals".

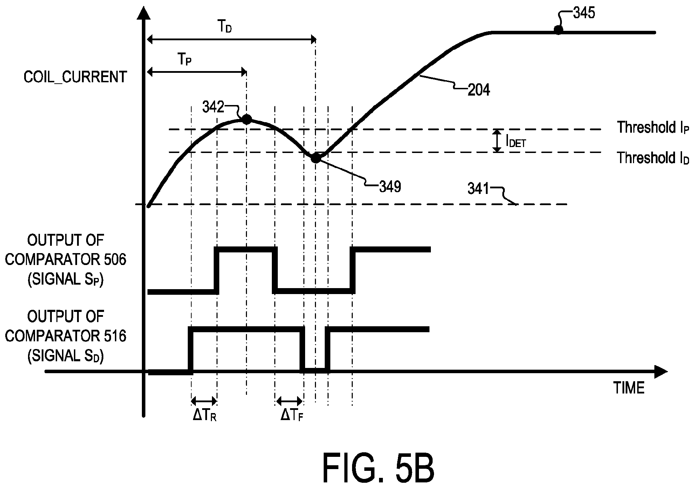

FIG. 5B is a graph illustrating aspects of the operation of the implementation of fault detector 117 that is shown in FIG. 5A. Shown in FIG. 5B is the curve 204, which represents the coil current of relay 100 under normal operating conditions. Dashed lines representing thresholds $I_P$ and $I_D$ are superimposed over curve 204 to illustrate the values of the thresholds $I_P$ and $I_D$. As illustrated the threshold $I_P$ may be set to a value that is less than or equal to the value which the positive peak 342 of the coil current of relay 100 is expected to have under normal operating conditions. Similarly, threshold $I_D$ may be set to the maximum value which negative peak 349 is expected to have under normal operating conditions. Comparator 506 may be configured to set signal $S_P$ to a first value (*e.g.,* logic-high) when the coil current of relay 100 is above threshold $I_P$. Furthermore, comparator 506 may be configured to set signal $S_P$ to a second value (*e.g.,* logic-low) when the coil current of relay 100 is below threshold $I_P$. Comparator 516 may be configured to set signal $S_P$ to a first value (*e.g.,* logic-high) when the coil current of relay 100 is above threshold $I_D$. Furthermore, comparator 516 may be configured to set signal $S_P$ to a second value (*e.g.,* logic-low) when the coil current of relay 100 is below threshold $I_D$.

Processing circuitry 501 may be configured to sample the values of signals $S_P$ and $S_D$, and the coil current of relay 100 and calculate metrics $T_D$, $T_P$, $\Delta T_R$, and $\Delta T_F$. The value of metric TP may be equal to (or otherwise based on) the duration of the period starting when the coil current of relay 100 crosses threshold 341 and ending when the coil current of relay 100 reaches the positive peak 342. The value of metric TD may be equal to (or otherwise based on) the duration of the period starting when the coil current of relay 100 crosses threshold 341 and ending when the coil current of relay 100 reaches the negative peak 349. The value of metric $\Delta T_R$ may be equal to (or otherwise based on) the time delay between a rising edge in signal $S_D$ and the first rising edge in signal $S_P$ that immediately follows the rising edge in signal $S_D$. The value of metric $\Delta T_F$ may be equal to (or otherwise based on) the time delay between a falling edge in signal $S_P$ and the first falling edge in signal $S_D$ that immediately follows the falling edge in signal $S_P$.

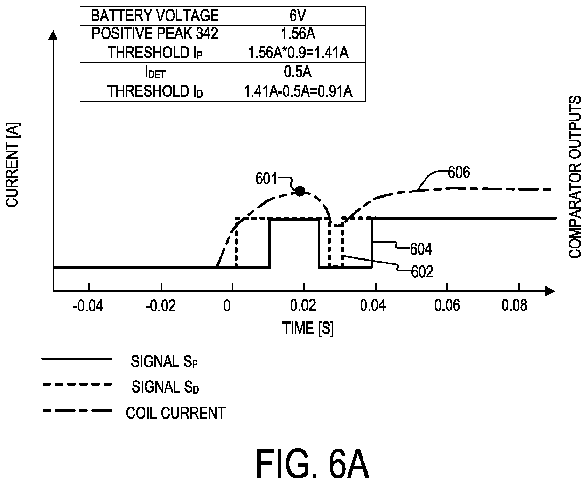

FIG. 6A is a graph showing the curves 602, 604, and 606. Curve 602 corresponds to signal $S_P$. Curve 604 corresponds to signal $S_P$. Curve 606 corresponds to the coil current of relay 100. In the example of FIG. 6A, relay 100 is driven using a 6V battery, and a positive peak 601 of the coil current is 1.56A. The threshold $I_P$ is equal to 90% of the positive peak value. The value of parameter $I_{DET}$ is set to 0.5A. In some implementations, the threshold $I_D$ may derived from the threshold $I_P$. For example, the threshold ID may be derived in accordance with one of equations 10 and 11:

$$I_D = I_P - IDET \quad (10)$$

$$I_D = I_P * F \quad (11)$$

Where IDET is a constant (*e.g.*, 0.5A) and F is also a constant which is less than 1 (F<1). In other words, in equation 10, the value threshold $I_D$ is obtained defined by subtracting constant IDET from the value of threshold $I_P$. And in equation 11, threshold $I_D$ is the defined as a fraction of the threshold IP (*e.g.*, 70%, etc.). Either one of constants IDET and F may be stored in memory 360. According to the present example, the value of threshold $I_D$ is set in accordance with equation 10.

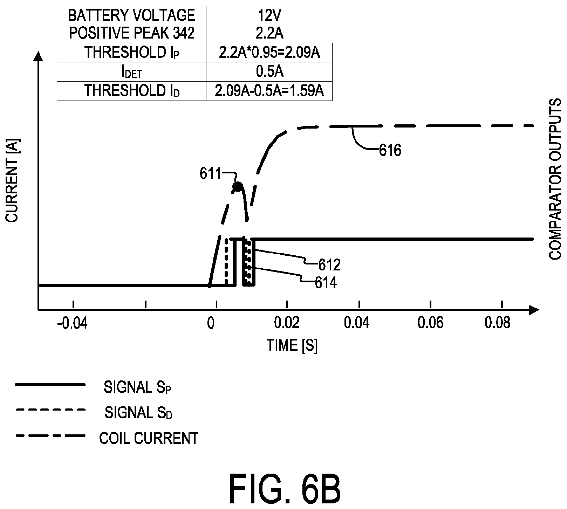

FIG. 6B is a graph showing the curves 612, 614, and 616. Curve 612 corresponds to signal $S_P$. Curve 614 corresponds to signal $S_P$. Curve 616 corresponds to the coil current of relay 100. In the example of FIG. 6B, relay 100 is driven using a 12V battery, and a positive peak 611 of the coil current is 2.2A. The threshold $I_P$ is equal to 90% of the positive peak value. The value of parameter $I_{DET}$ is set to 0.5A. And the threshold $I_D$ is equal to the threshold $I_P$ minus variable $I_{DET}$.

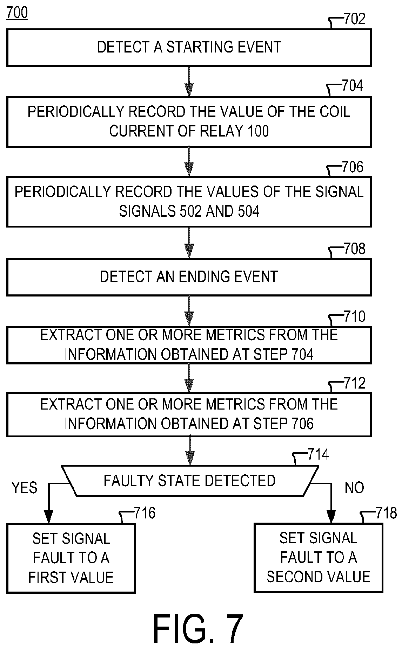

FIG. 7 is a flowchart of an example of a process 700, according to aspects of the disclosure.

At step 702, processing circuitry 501 detects a starting event. The starting event may be any event that signals that relay 100 is beginning to transition from the inactive state to the active state - *i.e.,* any event that signals that relay 100 is starting to close. In one example, detecting the starting event may include detecting that the coil current of relay 100 has increased past the threshold represented by threshold 341 (shown in FIG. 3B).

At step 704, processing circuitry 501 periodically records (and/or samples) the value of the coil current of relay 100.

At step 706, processing circuitry 501 periodically records (and/or samples) the value of signals SP and SD.

At step 708, processing circuitry 501 detects an ending event. The ending event may be any event that signals that relay 100 has transitioned into the active state- *i.e.,* any event that signals that relay 100 is closed. In one example, detecting the starting event may include detecting that the coil current of relay 100 has increased past the threshold 345 (shown in FIG. 3B).

At step 710, processing circuitry 501 extracts one or more metrics based on the values of the coil current that are collected at step 704. In one example, the coil current values collected at step 704 may be sufficient in number and frequency to represent the waveform of the coil current during the period starting when the starting event is detected and ending when the ending event is detected (hereinafter "period of interest"). According to the present example, the extracted metrics include the values $T_D$ and $T_P$, which are discussed above with respect to FIG. 5B.

At step 712, processing circuitry 501 extracts one or more metrics based on the information collected at step 706. In one example, the samples collected at step 706 may be sufficient in number and frequency to represent the waveform of signals $S_D$ and $S_P$ during the period of interest. According to the present example, the obtained metrics include the values $\Delta T_{F\,and}\,\Delta T_F$, which are discussed above with respect to FIG. 5B.

At step 714, processing circuitry 501 processes information obtained at steps 390, 392, and 394 to determine whether relay 100 is in a faulty state. If relay 100 is found to be in a faulty state, process 300E proceeds to step 716. Otherwise, if relay 100 is found to be operating normally (*i.e.,* not in a faulty state), process 300E proceeds to step 718.

At step 716, processing circuitry 501 sets signal FAULT to a first value (*e.g.,* '1').

At step 718, processing circuitry 501 sets signal FAULT to a second value (*e.g.,* '0').

Although in the present example, the signal FAULT is a 1-bit signal, in alternative implementations the signal FAULT may be a multi-bit signal. In such implementations, when the relay 100 is found to be in a faulty state, the value of the signal FAULT may be set to an error code that identifies the metric whose being out of bounds led processing circuitry 357 to conclude that relay 100 was in a faulty state.

In some implementations, processing circuitry 501 may determine that relay 100 is in a faulty state when any of the metrics obtained at steps 710 and 712 is out of bounds. According to the present example, any of the metrics obtained at steps 710 and 712 is out of bonds when the metric it fails to meet a lower bound threshold or an upper bound threshold. A metric may fail to meet a lower bound threshold, when the metric is less than the lower bound threshold. The metric may meet the lower bound threshold when the metric is greater than the lower bound threshold. On the other hand, the metric may fail to meet the upper bound threshold when the metric is greater than the upper bound threshold. The metric may meet the upper bound threshold when the metric is less than the upper bound threshold. Although, in the present example, each (or at least one) of the metrics obtained at steps 710 and 712 is compared against both an upper bond and a lower bound threshold for that metric, alternative implementations are possible in which the metric is compared against only one of the upper bound threshold or the lower bound threshold.

Additionally or alternatively, processing circuitry 501 may determine that relay 100 when the signals $S_D$ and $S_P$ indicate that the coil current of relay 100 has failed to cross at least one of the threshold $I_P$ and $I_D$ during the period of interest. In some implementations, if the thresholds $I_P$ and $I_D$ are crossed by the coil current of relay 100 and/or if all of the metrics obtained at steps 710 and 712 are within predetermined bounds, processing circuitry 501 may determine that relay 100 is operating normally.

The concepts and ideas described herein may be implemented, at least in part, via a computer program product, (e.g., in a non-transitory machine-readable storage medium such as, for example, a non-transitory computer-readable medium), for execution by, or to control the operation of, data processing apparatus (e.g., a programmable processor, a computer, or multiple computers). Each such program may be implemented in a high-level procedural or object-oriented programming language to work with the rest of the computer-based system. However, the programs may be implemented in assembly, machine language, or Hardware Description Language. The language may be a compiled or an interpreted language, and it may be deployed in any form, including as a stand-alone program or as a module, component, subroutine, or another unit suitable for use in a computing environment. A computer program may be deployed to be executed on one computer or multiple computers at one site or distributed across multiple sites and interconnected by a communication network. A computer program may be stored on a non-transitory machine-readable medium that is readable by a general or special-purpose programmable computer for configuring and operating the computer when the non-transitory machine-readable medium is read by the computer to perform the processes described herein. For example, the processes described herein may also be implemented as a non-transitory machine-readable storage medium, configured with a computer program, where upon execution, instructions in the computer program cause the computer to operate in accordance with the processes. A non-transitory machine-readable medium may include but is not limited to a hard drive, compact disc, flash memory, non-volatile memory, or volatile memory. The term unit (*e.g.,* an addition unit, a multiplication unit, *etc.*), as used throughout the disclosure may refer to hardware (*e.g.*, an electronic circuit) that is configured to perform a function (*e.g.,* addition or multiplication, *etc.*), software that is executed by at least one processor, and configured to perform the function, or a combination of hardware and software.

Also, for purposes of this description, the terms "couple," "coupling," "coupled," "connect," "connecting," or "connected" refer to any manner known in the art or later developed in which energy is allowed to be transferred between two or more elements, and the interposition of one or more additional elements is contemplated, although not required. Conversely, the terms "directly coupled," "directly connected," etc., imply the absence of such additional elements.

As used herein in reference to an element and a standard, the term "compatible" means that the element communicates with other elements in a manner wholly or partially specified by the standard, and would be recognized by other elements as sufficiently capable of communicating with the other elements in the manner specified by the standard. The compatible element does not need to operate internally in a manner specified by the standard.

Having described preferred embodiments, which serve to illustrate various concepts, structures and techniques, which are the subject of this patent, it will now become apparent that other embodiments incorporating these concepts, structures and techniques may be used. Accordingly, it is submitted that the scope of the patent should not be limited to the described embodiments but rather should be limited only by the spirit and scope of the following claims.

## Claims

1. A method, comprising:

   generating, by a peak detector, a comparison signal by comparing a coil current of a relay against a dynamic threshold, the comparison signal having a first value when the coil current is above the dynamic threshold, the comparison signal having a second value when the coil current is below the dynamic threshold, wherein the peak detector is configured to: cause the dynamic threshold to track the coil current until a positive peak in the coil current is reached that has a value PP, and set the dynamic threshold to a rebound value R in response to detecting that a negative peak in the coil current is reached, the rebound value R being based on the value PP; detecting whether the relay is in a faulty state based on the comparison signal; and generating an indication of a fault when the relay is detected to be in a faulty state.

2. A system, comprising:

   a peak detector that is configured to generate a comparison signal by comparing a coil current of a relay against a dynamic threshold, the comparison signal having a first value when the coil current is above the dynamic threshold, the comparison signal having a second value when the coil current is below the dynamic threshold, wherein generating the comparison signal includes causing the dynamic threshold to track the coil current until a positive peak in the coil current is reached that has a value PP, and setting the dynamic threshold to a rebound value R in response to detecting that a negative peak in the coil current is reached, the rebound value R being based on the value PP; and

a processing circuitry that is configured to detect whether the relay is in a faulty state based on the comparison signal, and generate an indication of a fault when the relay is detected to be in a faulty state.

3. The system of claim 2, or the method of claim 1, wherein the peak detector is further configured to set the dynamic threshold based on a difference between the value PP and a value M in response to detecting the positive peak.

4. The system of claim 2, or the method of claim 1, wherein the rebound value R is equal to the value PP.

5. The system of claim 2, or the method of claim 1, wherein detecting whether the relay is in a faulty state includes identifying a count of artifacts of back electromotive force (BEMF) action in the comparison signal and determining that the relay is in a faulty state in response to the count being less than or greater than one.

6. The system of claim 2, or the method of claim 1, wherein detecting whether the relay is in a faulty state further includes identifying a difference between the positive peak and the negative peak, and determining that the relay is in a faulty state when the difference is less than a first threshold and/or greater than the second threshold, the second threshold being greater than the first threshold.

7. The system of claim 2, or the method of claim 1, wherein the detecting of whether the relay is in a faulty state is further performed based on a slope of a portion of a waveform of the coil current.

8. The system of claim 2, or the method of claim 1, wherein detecting whether the relay is in a faulty state includes identifying a measure of a duration of a dip in the coil current, and determining that the relay is in a faulty state when the measure is less than a first threshold and/or greater than a second threshold, the second threshold being greater than the first threshold.

9. The system or method of claim 8, wherein the measure is identified based on the comparison signal.

10. The system of claim 2, or the method of claim 1, wherein the detecting of whether the relay is in a faulty state is performed further based on at least one metric value that is adjusted based on temperature and/or battery voltage.

11. The system of claim 2, or the method of claim 1, wherein the peak detector is configured to set the dynamic threshold based, at least in part, on temperature and/or battery voltage.

12. A method, comprising:

generating a comparison signal $S_P$ by using a first comparator, the comparison signal $S_P$ having a first value when a coil current of a relay is above a threshold $I_P$ and a second value when the coil current is below the threshold $I_P$; generating a comparison signal $S_D$ by using a second comparator, the comparison signal $S_D$ having the first value when a coil current of a relay is above a threshold $I_D$ and the second value when the coil current is below the threshold $I_D$; detecting whether the relay is in a faulty state based on the comparison signals $S_D$ and $S_P$; and generating an indication of a fault when the relay is detected to be in a faulty state.

13. The method of claim 12, wherein:

detecting whether the relay is in a faulty state includes identifying a delay between a first type-1 edge in one of the comparison signals $S_P$ and $S_D$ and a second type-1 edge in the other one of the comparison signals $S_P$ and $S_D$, and determining that relay is in a faulty state when the delay fails to meet a delay threshold, and the second type-1 edge is a first type-1 edge in the other one of the comparison signals $S_P$ and $S_D$ that is generated after the first type-1 edge.

14. The method of claim 12, further comprising detecting a delay between a starting event and one of a positive peak and a negative peak in the coil current of the relay, wherein the detection of whether the relay is in a faulty state is further based on the delay.

15. A system, comprising:

a first comparator that is configured to generate a comparison signal $S_P$, the comparison signal $S_P$ having a first value when a coil current of a relay is above a threshold $I_P$ and a second value when the coil current is below the threshold $I_P$; a second comparator that is configured to generate a comparison signal $S_D$, the comparison signal $S_D$ having the first value when a coil current of a relay is above a threshold $I_D$ and the second value when the coil current is below the threshold $I_D$; and a processing circuitry that is configured to detect whether the relay is in a faulty state based on the comparison signals $S_D$ and $S_P$, and generate an indication of a fault when the relay is detected to be in a faulty state.

**16.** The system of claim 15, wherein:

detecting whether the relay is in a faulty state includes identifying a delay between a first type-1 edge in one of the comparison signals $S_P$ and $S_D$ and a second type-1 edge in the other one of the comparison signals $S_P$ and $S_D$, and determining that relay is in a faulty state when the delay fails to meet a delay threshold, and the second type-1 edge is a first type-1 edge in the other one of the comparison signals SP and SD that is generated after the first type-1 edge.

**17.** The system of claim 16, or the method of claim 13, wherein the first type-1 edge is a rising edge and the second type-1 edge is a rising edge.

**18.** The system of claim 16, or the method of claim 13, wherein the first type-1 edge is a falling edge and the second type-1 edge is a falling edge.

**19.** The system of claim 16, or the method of claim 13, wherein the delay threshold is an upper bound threshold, the delay meets the upper bound threshold when the delay is less than the upper bound threshold, and the delay fails to meet the upper bound threshold when the delay is greater than the upper bound threshold.

**20.** The system of claim 16, or the method of claim 13, wherein the delay threshold is a lower bound threshold, the delay meets the lower bound threshold when the delay is greater than the lower bound threshold, and the delay fails to meet the lower bound threshold when the delay is less than the lower bound threshold.

**21.** The system of claim 15, wherein the processing circuitry is further configured to detect a delay between a starting event and one of a positive peak and a negative peak in the coil current of the relay, and the detection of whether the relay is in a faulty state is further based on the delay.

FIG. 1

FIG. 2A

TIME [S]

FIG. 2B

FIG. 3A

FIG. 3B

FIG. 3C

POSITIVE PEAK DETECTED IN THE
COIL CURRENT OF RELAY 100

STATE 1

SIG='1'

STATE 2

SIG='1'

AFTER REACHING A NEGATIVE
PEAK, THE COIL CURRENT OF
RELAY 100 REBOUNDS TO THE
VALUE IT HAD AT THE MOST
RECENT POSITIVE PEAK

THE COIL CURRENT OF RELAY 100
DECREASES BY A PREDETERMINED
AMOUNT FROM THE VALUE IT HAD AT
THE POSITIVE PEAK

STATE 3

SIG='0'

# FIG. 3D

300E

DETECT A STARTING EVENT ⌐382

PERIODICALLY RECORD THE VALUE OF THE COIL CURRENT OF RELAY 100 ⌐384

PERIODICALLY RECORD THE VALUE OF THE SIGNAL SIG ⌐386

OBTAIN ADDITIONAL INFORMATION THAT IS GENERATED BY A PEAK DETECTOR ⌐388

DETECT AN ENDING EVENT ⌐390

EXTRACT ONE OR MORE METRICS FROM THE INFORMATION OBTAINED AT STEP 384 ⌐392

EXTRACT ONE OR MORE METRICS FROM THE INFORMATION OBTAINED AT STEP 386 ⌐394

FAULTY STATE DETECTED ⌐396

YES

NO

SET SIGNAL FAULT TO A FIRST VALUE ⌐397

SET SIGNAL FAULT TO A SECOND VALUE ⌐399

FIG. 3E

FIG. 4A

FIG. 4B

FIG. 4C

LEGEND
CURVE 204 (THICKER LINE) – REPRESENTS COIL CURRENT
CURVE 479 (THINER LINE) – REPRESENTS THE THRESHOLD OF PEAK DETECTOR 358

FAULT DETECTOR 119

PROCESSING CIRCUITRY

DAC 504

DAC 514

COIL_CURRENT

COIL CURRENT

$S_P$

$I_P$

$I_D$

$S_D$

FAULT

501

506

516

FIG. 5A

FIG. 5B

26

EP 4 704 130 A1

| BATTERY VOLTAGE | 6V |
|---|---|
| POSITIVE PEAK 342 | 1.56A |
| THRESHOLD $I_P$ | 1.56A*0.9=1.41A |
| $I_{DET}$ | 0.5A |
| THRESHOLD $I_D$ | 1.41A-0.5A=0.91A |

CURRENT [A]

COMPARATOR OUTPUTS

601

606

604

602

-0.04  -0.02  0  0.02  0.04  0.06  0.08

TIME [S]

———— SIGNAL $S_P$

- - - - - SIGNAL $S_D$

—·—·— COIL CURRENT

FIG. 6A

| BATTERY VOLTAGE | 12V |
|---|---|
| POSITIVE PEAK 342 | 2.2A |
| THRESHOLD $I_P$ | 2.2A*0.95=2.09A |
| $I_{DET}$ | 0.5A |
| THRESHOLD $I_D$ | 2.09A-0.5A=1.59A |

SIGNAL $S_P$

SIGNAL $S_D$

COIL CURRENT

**FIG. 6B**

700                                                                    ┌—702
┌─────────────────────────────────────────────────────┐
│              DETECT A STARTING EVENT                 │
└─────────────────────────────────────────────────────┘
                            │
                            ▼                          ┌—704
┌─────────────────────────────────────────────────────┐
│      PERIODICALLY RECORD THE VALUE OF THE COIL       │
│              CURRENT OF RELAY 100                    │
└─────────────────────────────────────────────────────┘
                            │
                            ▼                          ┌—706
┌─────────────────────────────────────────────────────┐
│      PERIODICALLY RECORD THE VALUES OF THE SIGNAL    │
│              SIGNALS 502 AND 504                     │
└─────────────────────────────────────────────────────┘
                            │
                            ▼                          ┌—708
┌─────────────────────────────────────────────────────┐
│              DETECT AN ENDING EVENT                  │
└─────────────────────────────────────────────────────┘
                            │
                            ▼                          ┌—710
┌─────────────────────────────────────────────────────┐
│     EXTRACT ONE OR MORE METRICS FROM THE            │
│         INFORMATION OBTAINED AT STEP 704             │
└─────────────────────────────────────────────────────┘
                            │
                            ▼                          ┌—712
┌─────────────────────────────────────────────────────┐
│     EXTRACT ONE OR MORE METRICS FROM THE            │
│         INFORMATION OBTAINED AT STEP 706             │
└─────────────────────────────────────────────────────┘
                            │
                            ▼                          ┌—714
          ╱───────────────────────────────────────╲
   YES    ╲        FAULTY STATE DETECTED           ╱    NO
      ┌────╱───────────────────────────────────────╲────┐
      │         ┌—716                                    │         ┌—718
      ▼                                                  ▼
┌──────────────┐                              ┌──────────────┐
│  SET SIGNAL  │                              │  SET SIGNAL  │
│  FAULT TO A  │                              │  FAULT TO A  │
│  FIRST VALUE │                              │ SECOND VALUE │
└──────────────┘                              └──────────────┘

# FIG. 7

Europäisches
Patentamt

European
Patent Office

Office européen
des brevets

## EUROPEAN SEARCH REPORT

**Application Number**

EP 25 19 6804

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 7 705 601 B2 (EATON CORP [US]) 27 April 2010 (2010-04-27) * column 8, line 51 - column 9, line 51; figures * | 1-21 | INV. H01H47/00 G01R31/327 |
| A | CA 3 072 812 A1 (SENSUS SPECTRUM LLC [US]) 21 February 2019 (2019-02-21) * page 8, line 3 - page 9, line 32; figures * | 1,2,12, 15 | |
| A | US 8 699 201 B2 (KOHRI YUUSUKE [JP]; SANO TAKESHI [JP]; RICOH CO LTD [JP]) 15 April 2014 (2014-04-15) * column 8, line 30 - column 9, line 19; figures 1-11 * | 1,2,12, 15 | |

**TECHNICAL FIELDS
SEARCHED      (IPC)**

H01H
G01R

The present search report has been drawn up for all claims

| Place of search | Date of completion of the search | Examiner |
|---|---|---|
| Munich | 16 December 2025 | Findeli, Luc |

CATEGORY OF CITED DOCUMENTS

X : particularly relevant if taken alone
Y : particularly relevant if combined with another
      document of the same category
A : technological background
O : non-written disclosure
P : intermediate document

T : theory or principle underlying the invention
E : earlier patent document, but published on, or
      after the filing date
D : document cited in the application
L : document cited for other reasons

& : member of the same patent family, corresponding
      document

EPO FORM 1503 03.82 (P04C01)

## ANNEX TO THE EUROPEAN SEARCH REPORT
## ON EUROPEAN PATENT APPLICATION NO.

EP 25 19 6804

This annex lists the patent family members relating to the patent documents cited in the above-mentioned European search report.
The members are as contained in the European Patent Office EDP file on
The European Patent Office is in no way liable for these particulars which are merely given for the purpose of information.

16-12-2025

| Patent document cited in search report | | Publication date | Patent family member(s) | | Publication date |
|---|---|---|---|---|---|
| US 7705601 | B2 | 27-04-2010 | NONE | | |
| CA 3072812 | A1 | 21-02-2019 | CA | 3072812 A1 | 21-02-2019 |
| | | | SA | 520411386 B1 | 12-02-2023 |
| | | | US | 2019057827 A1 | 21-02-2019 |
| | | | WO | 2019036644 A2 | 21-02-2019 |
| US 8699201 | B2 | 15-04-2014 | JP | 5636980 B2 | 10-12-2014 |
| | | | JP | 2011215131 A | 27-10-2011 |
| | | | US | 2011228438 A1 | 22-09-2011 |

EPO FORM P0459

For more details about this annex : see Official Journal of the European Patent Office, No. 12/82